# EUROPEAN PATENT APPLICATION

(11) **EP 1 383 243 A1**
(43) Date of publication of application: **21.01.2004**
(21) Application number: 03102218.9
(22) Date of filing: 18.07.2003
(51) Int. Cl.: H03L 7/093

(54) **Locked Loop Circuit Design with Diode for Loop Filter Capacitance Leakage Current Control**

(30) Priority: 19.07.2002 US 199423; 19.07.2002 US 199426
(71) Applicant: Sun Microsystems, Inc., Santa Clara, California 95054 (US)
(72) Inventor: TRIVEDI, Pradeep, 94086, Sunnyvale (US); BOBBA, Sudhakar, 94085, Sunnyvale (US); GAUTHIER, Claude, 95014, Cupertino (US); LIU, Dean, 94086, Sunnyvale (US)
(74) Representative: Weihs, Bruno

(57) **Abstract**

A locked loop circuit de sign that uses a diode operatively connected to a loop filter capacitor to control a leakage current of the loop filter capacitor is provided. By positioning a diode in series with the loop filter capacitor, a voltage potential across the loop filter capacitor is reduced, thereby reducing the leakage current of the loop filter capacitor. Moreover, the leakage current of the loop filter capacitor is controlled in that it cannot exceed the current through the diode. Control and reduction of the loop filter capacitor leakage current leads to more reliable and stable locked loop circuit behavior.

## Description

### Background of Invention

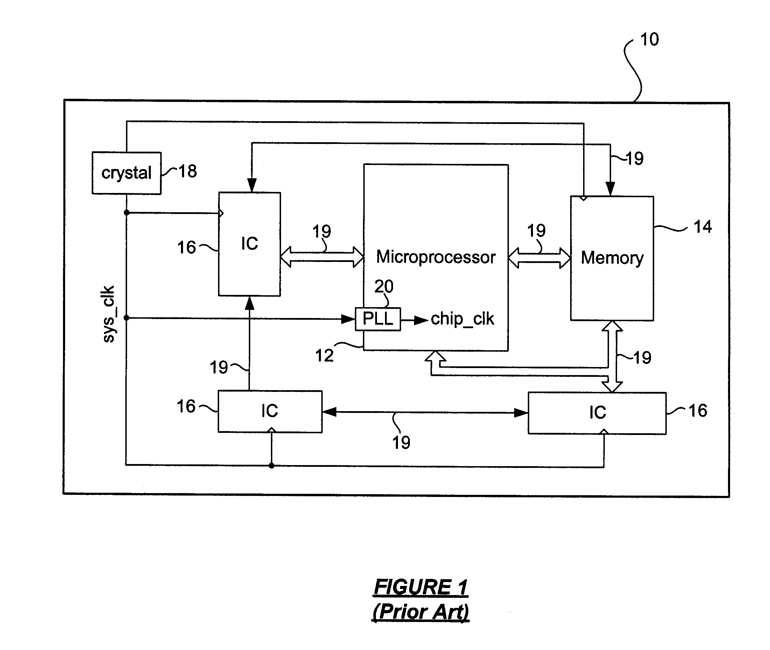

As shown in Figure 1, a typical computer system **10** has, among other components, a microprocessor **12**, one or more forms of memory **14**, integrated circuits **16** having specific functionalities, and peripheral computer resources (not shown), e.g., monitor, keyboard, software programs, etc. These components communicate with one another via communication paths **19**, e.g., wires, buses, etc., to accomplish the various tasks of the computer system **10**.

In order to properly accomplish such tasks, the computer system **10** relies on the basis of time to coordinate its various operations. To that end, a crystal oscillator **18** generates a system clock signal (refe rred to and known in the art as "reference clock" and shown in Figure 1 as sys_clk) to various parts of the computer system **10.** Modern microprocessors and other integrated circuits, however, are typically capable of operating at frequencies significantly higher than the system clock, and thus, it becomes important to ensure that operations involving the microprocessor **12** and the other components of the computer system **10** use a proper and accurate reference of time.

### Phase Locked Loop Circuits

One component used within the computer system **10** to ensure a proper reference of time among a system clock and a microprocessor clock, i.e., "chip clock," is a type of clock generator known as a phase locked loop, or "PLL" **20**. The PLL **20** is an electronic circuit that controls an oscillator such that the oscillator maintains a constant phase relative to a reference signal. Referring to Figure 1, the PLL **20** has as its input the system clock, which is its reference signal, and outputs a chip clock signal (shown in Figure 1 as chip_clk) to the microprocessor **12.** The system clock and chip clock have a specific phase and frequency relationship that is controlled and maintained by the PLL **20**. This relationship between the phases and frequencies of the system clock and chip clock ensures that the various components within the microprocessor **12** use a controlled and accounted for reference of time. When this relationship is not maintained by the PLL **20**, however, the operations within the computer system **10** may become non-deterministic.

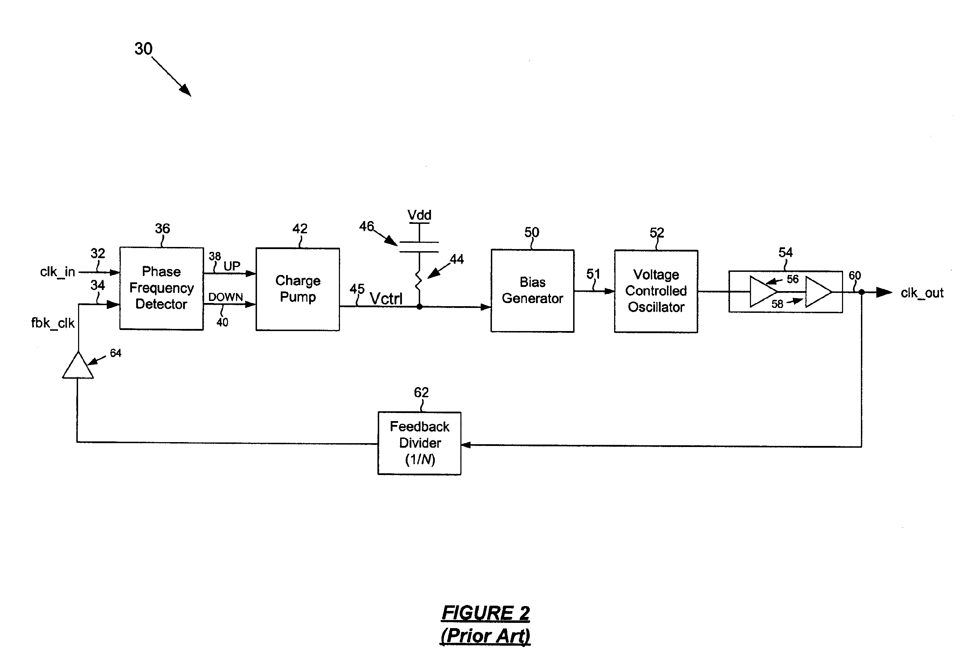

Figure 2 shows a diagram of a typical PLL **30.** The PLL **30** uses a phase frequency detector **36** that operatively receives an input clock signal, clk_in **32,** and a feedback clock signal, fbk_clk **34.** The phase frequency detector **36** compares the phases of the input clock signal **32** and the feedback clock signal **34,** and dependent on the comparison, the phase frequency detector **36** outputs pulses on UP **38** and DOWN **40** signals to a charge pump **42**. Depending on the pulses on the UP **38** and DOWN **40** signals, the charge pump **42** transfers charge to or from a loop filter capacitor **46** via a control voltage signal, Vctrl **45**. Those skilled in the art will understand that the loop filter capacitor 46 along with a loop filter resistor **44** form a 'loop filter' of the PLL **30**.

The control voltage signal **45** serves as an input to a bias generator **50**, which, in turn, outputs at least one bias signal **51** to a voltage -controlled oscillator **52.** The voltage-controlled oscillator (VCO) **52,** dependent on the at least one bias signal **51,** outputs a clock signal, clk_out **60,** that (1) propagates through a clock distribution network **54** (modeled in Figure 2 as buffers **56** and **58)** and (2) serves as an output of the PLL **30**. The output clock signal **60** is fed back through a feedback divider **62**, which, in turn, outputs to a buffer **64** that generates the feedback clock signal **34** to the phase frequency detector **36**.

### Delay Locked Loop Circuits

As the frequencies of modern computers continue to increase, the need to rapidly transmit data between circuit interfaces also increases. To accurately receive data, a clock signal is often transmitted to help recover data transmitted to a receiving circuit by some transmitting circuit. The clock signal determines when the data should be sampled by the receiving circuit. Typically, the receiving circuit operates better when the clock signal is detected during the middle of the time the data is valid. To this end, a delay locked loop ("DLL") is commonly used to generate a copy of the clock signal at a fixed phase shift with respect to the original clock signal.

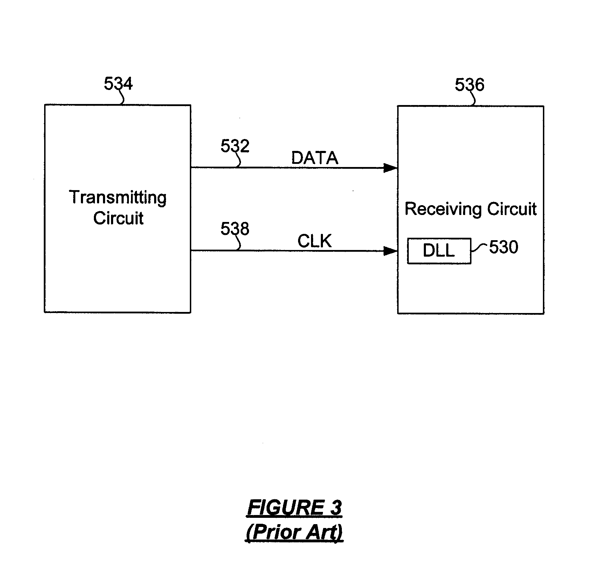

Figure 3 shows a portion of a typical computer system in which a DLL **530** is used. In Figure 3, data **532** is transmitted from a transmitting circuit **534** to a receiving circuit **536**. To aid in the recovery of the data **532** by the receiving circuit **536**, a clock signal **538** is transmitted along with the data **532**. To ensure that the data 532 is properly latched by the receiving circuit **536**, the DLL **530** (which in Figure 3 is shown as being part of the receiving ci rcuit **536**) regenerates the clock signal **538** to a valid voltage level and creates a phase shifted version of the clock signal **538**. Accordingly, the use of the DLL **530** in this fashion ensures (1) that the data **532** is properly latched by triggering the recei ving circuit **536** at a point in time in which the data **532** is valid.

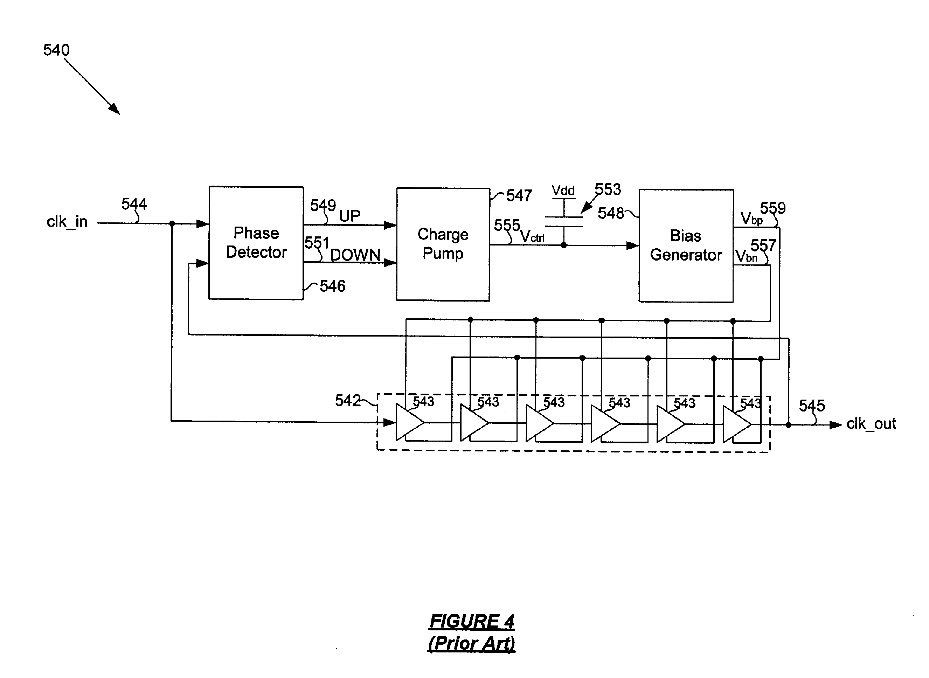

Figure 4 shows a configuration of a typical DLL **540**. The DLL **540** uses a voltage-controlled delay line **542,** composed of several delay elements **543,** to delay an output clock signal, clk_out **545,** with a fixed phase shift relative to an input clock signal, clk_in **544.** A delay of the voltage -controlled delay line **542** is controlled by a feedback system including a phase detector **46,** a charge pump **47,** and a bias generator **548**. The phase detector **546** detects any phase offset (i.e., phase difference) between the input clock signal **544** and the output clock signal **545** and then accordingly generates pulses on UP **549** and DOWN **551** signals that control the charge pump **547**. Depending on the UP **549** and DOWN **551** pulses, the charge pump **547** transfers charge to or from a loop filter capacitor **553** via a control voltage signal, Vctrl **555**. The bias generator **548** receives the control voltage signal **555** and produces bias voltages Vbn **557** and Vbp **559** that adjust the delay of the delay elements **543** in the voltage-controlled delay line **542**. The DLL **540** is arranged such that the delay of the voltage -controlled delay line **542** attempts to maintain 180 degree phase shift between the input clock signal **544** and the output clock signal **545**.

For a more detailed background on the operation and behavior of PLLs and DLLs, see J. Maneatis, "Low-Jitter Process-Independent DLL and PLL Based on Self-Biased Techniques," IEEE Journal of Solid -State Circuits, vol. 31, no. 11, November 1996.

### Summary of Invention

According to one aspect of the present invention, an integrated circuit comprises a detector arranged to detect a phase difference between a first clock signal and a second clock signal, a charge pump arranged to output a con trol voltage signal dependent on the phase difference; an on -chip capacitor operatively connected to the control voltage signal, a diode operatively connected in series with the capacitor, and a voltage -controlled device arranged to output the second clock signal dependent on the control voltage signal.

According to one aspect of the present invention, an integrated circuit comprises means for detecting a phase difference between a first clock signal and a second clock signal, means for generating a signal dependent on the phase difference, means for storing charge on -chip to maintain a voltage potential on the signal, a diode positioned in series with the means for storing and arranged to control a leakage current of the means for storing charge, and means for generating the second clock signal dependent on the signal.

According to one aspect of the present invention, a method for performing a locked loop circuit operation comprises comparing a phase difference between a first clock signal and a second clock signal, generating a control voltage signal dependent on the comparing, storing charge dependent on the control voltage signal using an on-chip capacitor, controlling a leakage current of the capacitor with a diode positioned in series with the capacitor, and generating the second clock signal dependent on the control voltage signal.

Other aspects and advantages of the invention will be apparent from the following description and the appended claims.

### Brief Description of Drawings

Figure 1 shows a typical computer system.

Figure 2 shows a typical phase locked loop circuit.

Figure 3 shows a portion of a typical computer system in which a delay locked loop is used.

Figure 4 shows a typical delay locked loop.

Figure 5 shows a phase locked loop circuit in accordance with an embodiment of the present invention.

Figure 6 shows a delay locked loop circuit in accordance with an embodiment of the present invention.

Figure 7 shows a portion of the locked loop circuit in accordance with an embodiment of the present invention.

Figure 8 shows a portion of the locked loop circuit in accordance with an embodiment of the present invention.

### Detailed Description

As device features, such as transistor features, used to implement integrated circuit components, e.g., locked loop circuits (e.g., PLLs and DLLs), continue to get smaller, they may have higher leakage currents (i.e., higher gate tunneling currents). This is due to the fact that as transistor features are designed smaller, the thickness of the transistor's oxide layer (located between the transistor's gate and the semiconductor substrate) is reduced. As the oxide layer is reduced to a few angstroms, the transistor's gate terminal begins to leak charge to the other terminals of the transistor. In the case of a locked loop circuit's loop filter capacitor, which is typically desired to be large from a capacitance perspective and that can be implemented with a transistor, such reduction in transistor size features and consequential increase in leakage current can adversely affect the behavior of the locked loop circuit. In some cases, particular amounts of leakage current through the locked loop circuit's loop filter capacitor can even cause the locked loop circuit to malfunction. Accordingly, there is a need for a locked loop circuit design that guards against or compensates for a locked loop circuit loop filter capacitor's leakage current.

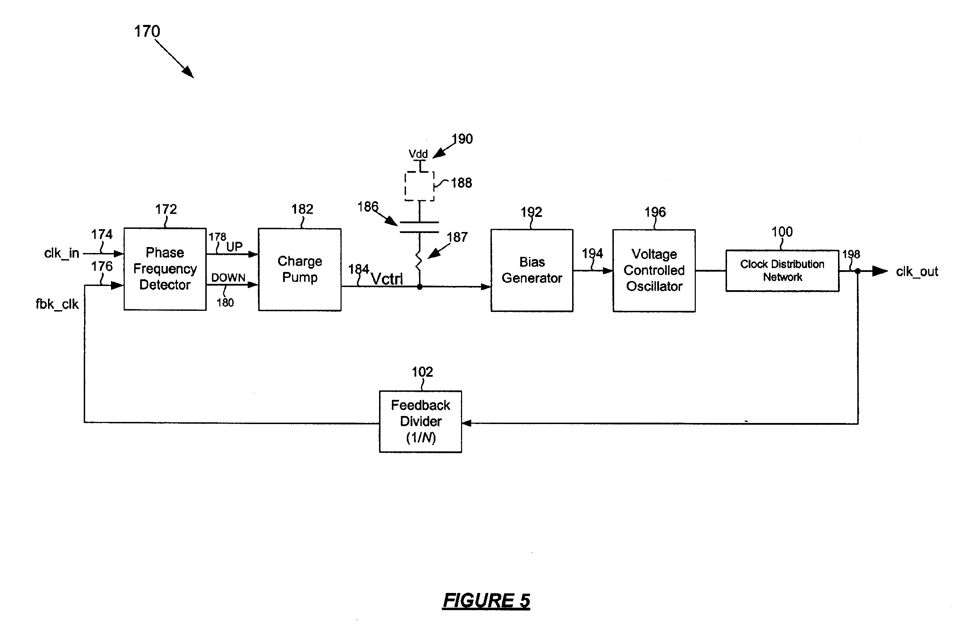

Figure 5 shows a PLL **170** in accordance with an embodiment of the present invention. The PLL **170** uses a phase frequency detector **172** that detects a phase difference between an input clock signal, clk_in **174,** and a feedback clock signal, fbk_clk **176.** Dependent on the phase difference detected by the phase frequency detector **172,** the phase frequency detector **172** outputs pulses on UP **178** and DOWN **180** signals to a charge pump **182**. The charge pump **182**, dependent on the pulses on the UP **178** and DOWN **180** signals, generates a control voltage signal, Vctrl **184**.

For stability, the PLL **170** uses a loop filter, formed by a loop filter capacitor **186** and a loop filter resistor **187**, that is operatively connected to the control voltage signal **184.** The loop filter capacitor **186** stores/dissipates charge dependent on the control voltage signal **184**. Those skilled in the art will understand that the loop filter capacitor **186** may be implemented using the gate capacitance of a metal-oxide semiconductor field-effect transistor (MOSFET). The UP **178** and DOWN **180** signals are pulsed only once per clock cycle, and therefore, the control voltage signal **184** may not be maintained due to the leakage current of the loop filter capacitor **186**. To guard against increased leakage currents associated with smaller transistor features, a first terminal of a diode **188** is connected to the loop filter capacitor **186**. In other words, the diode **188** is positioned in series with the loop filter capacitor **186**. A second terminal of the diode **188** is connected to a voltage potential Vdd **190**. Those skilled in the art will note, that in one or more other embodiments, the second terminal of the diode **188** may be connected to a voltage potential Vss (not shown) instead of the voltage potential Vdd **190**.

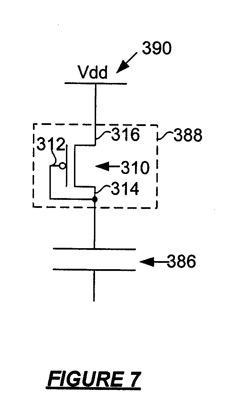

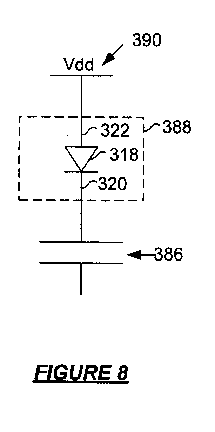

By connecting the diode **188** in series with the loop filter capacitor **186**, the voltage potential across the loop filter capacitor **186** is reduced relative to the case in which there is no diode and the loop filter is connected across the control voltage signal **184** and the voltage potential Vdd **190**. Accordingly, by reducing the voltage potential across the loop filter capacitor **86**, the leakage current of the loop filter capacitor **186** is reduced, which, in turn, promotes stable and reliable PLL **170** operation. Moreover, those skilled in the art will understand that the diode **188** should have a maximum leakage current less than that of the loop fil ter capacitor **186**. The implementation of the diode **188** is further described below with reference to Figures 7 and 8.

Referring to Figure 5, the control voltage signal **184** serves as an input to a bias generator **192** that produces at least one bias signal **194** to a voltage-controlled oscillator (VCO) **196**. The voltage-controlled oscillator **196**, dependent on the at least one bias signal **194** from the bias generator **192**, generates an output clock signal, clk_out **198.** The output clock signal **198,** in addition to serving as an output of the PLL **170,** is fed back to an input of the phase frequency detector **172** through a clock distribution network **100** and a feedback divider **102**. Those skilled in the art will note that, in one or more other embodiments, the PLL **170** may be implemented without the bias generator **192** by operatively connecting the voltage-controlled oscillator **196** with the control voltage signal **184**.

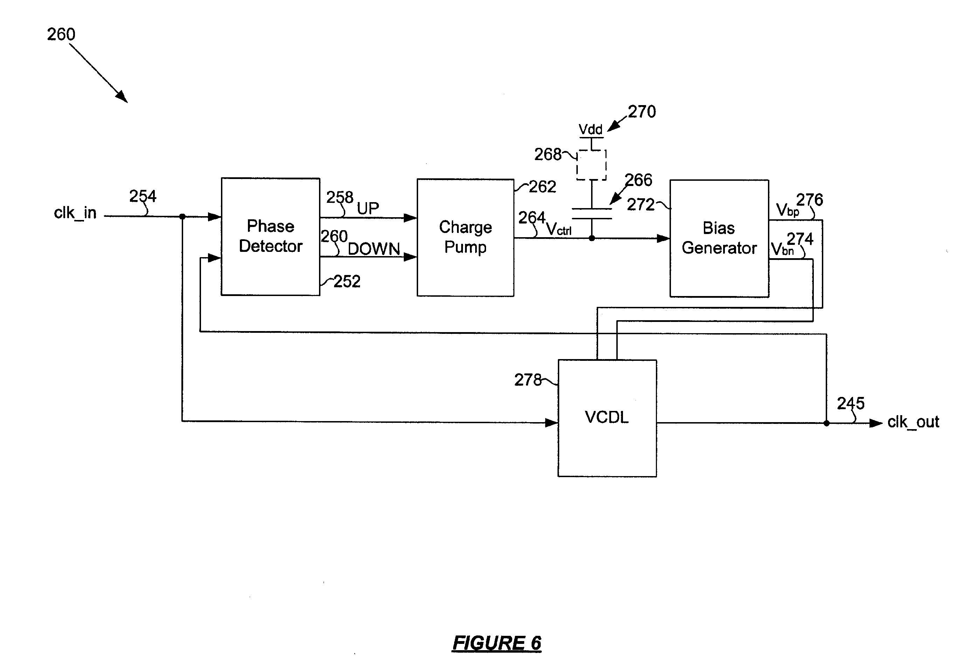

Figure 6 shows a DLL **250** in accordance with an embodiment of the present invention. The DLL **250** uses a phase detector **252** that detects a phase difference between an input clock signal, clk_in **254,** and an output clock signal, clk_out **256.** Dependent on the phase difference detected by the phase detector **252,** the phase detector **252** outputs pulses on UP **258** and DOWN **260** signals to a charge pump **262**. The charge pump **262**, dependent on the pulses on the UP **258** and DOWN **260** signals, generates a control voltage signal, Vctrl 264.

For stability, the DLL **250** uses a loop filter capacitor **266** that is operatively connected to the control voltage signal **264.** The loop filter capacitor **266** stores/dissipates charge dependent on the control voltage signal **264.** Those skilled in the art will understand that the loop filter capacitor **266** may be implemented using the gate capacitance of a metal-oxide semiconductor field-effect transistor (MOSFET). The UP **258** and DOWN **260** signals are pulsed only once per clock cycle, and therefore, the control voltage signal **264** may not be maintained due to the leakage current of the loop filter c apacitor **266**. To guard against increased leakage currents associated with smaller transistor features, a first terminal of a diode **268** is connected to the loop filter capacitor **266**. In other words, the diode **268** is positioned in series with the loop filter capacitor **266.** A second terminal of the diode **268** is connected to a voltage potential Vdd **270**. Those skilled in the art will note, that in one or more other embodiments, the second terminal of the diode **268** may be connected to a voltage potential Vss (not shown) instead of the voltage potential Vdd **270**.

By connecting the diode **268** in series with the loop filter capacitor **266**, the voltage potential across the loop filter capacitor **266** is reduced relative to the case in which there is no diode and the lo op filter capacitor **266** is connected across the control voltage signal **264** and the voltage potential Vdd **270**. Accordingly, by reducing the voltage potential across the loop filter capacitor **266**, the leakage current of the loop filter capacitor **266** is reduced, which, in turn, promotes stable and reliable DLL **250** operation. Moreover, those skilled in the art will understand that the diode **268** should have a maximum leakage current less than that of the loop filter capacitor **266**. As discussed above, the implementation of the diode **268** is further described below with reference to Figures 7 and 8.

Still referring to Figure 6, the control voltage signal **264** serves as an input to a bias generator **272** that produces bias signals Vbn and Vbp **274** and **276** to a voltage controlled delay line **278**. The voltage controlled delay line **278** inputs the input clock signal **254** and provides a delay dependent on the bias signals **274** and **276** in order to generate the output clock signal **256**. The output clock signal **256**, in addition to serving as an output of the DLL **250**, is fed back to an input of the phase detector **252**. Those skilled in the art will note that, in one or more other embodiments, the DLL **250** may be implemented without the bias generator **272** by operatively connecting the voltage controlled delay line **278** with the control voltage signal **264**.

Figure 7 shows an implementation of the diode **388** (e.g., **188** and **268** shown in Figures 5 and 6, respectively) in accordance with an embodiment of the present invention. In Figure 7, the diode **388** is implemented with a p -channel transistor **310** that has its gate terminal **312** connected to its drain terminal **314**. The p-channel transistor's **310** source terminal **316** is connected to the voltage potential Vdd **390.** Accordingly, the p -channel transistor **310** is said to be "diode - connected."

Due to this configuration, the leakage current of the loop filter capacitor **386** (e.g., **86** and **66** in Figures 5 and 6, respectively) is controlled because it cannot get larger than the source to drain current of the diode-connected p-channel transistor **310**. Moreover, due to the voltage drop across the diode -connected p-channel transistor **310**, the voltage potential across the loop filter capacitor **386** is reduced, which, in turn, reduces the leakage current of the loop filter capacitor **386**.

Those skilled in the art will note that, in one or more other embodiments, a diode-connected transistor positioned in series with a locked loop circuit loop filter capacitor may be connected to a voltage potential Vss (i.e. , a ground potential), in which case, the diode -connected transistor could be implemented with an n-channel transistor.

Figure 8 shows another implementation of the diode **388** shown in Figure 7 in accordance with an embodiment of the present invention. In Figure 8, the diode **388** is implemented with a p-n junction diode **318** that has its cathode terminal **320** connected to the loop filter capacitor 386 and its anode terminal **322** connected to the voltage potential Vdd **30**.

Due to this configuration, the leakage current of the loop filter capacitor **386** is controlled because it cannot get larger than the current through the p -n junction diode **318**. Moreover, due to the voltage drop across the p -n junction diode **318,** the voltage potential across the loop filter capacitor **386** is reduced, which, in turn, reduces the leakage current of the loop filter capacitor **386**.

Those skilled in the art will note that, in one or more other embodiments, a p-n junction diode positioned in series with a locked loop circuit loop filter capacitor may be connected to a voltage potential Vss (i.e., a ground potential), in which case, the p-n junction diode would have its anode terminal connected to the locked loop circuit loop filter capacitor and its cathode terminal connected to the voltage potential Vss.

Those skilled in the art will further note that p -n junction devices that may be positioned in series with the loop filter capacitor **386** include, among other types, rectifier diodes, Schottky diodes, and Zener diodes.

Advantages of the present invention may include one or more of the following. In one or more embodiments, because a leakage current of a locked loop circuit loop filter capacitor may be controlled, a more stable and reliable operation of the locked loop circuit may be fac ilitated. Accordingly, the phase shift of the locked loop circuit may not drift or may not drift as much as a locked loop circuit design without a diode.

In one or more embodiments, because a diode positioned in series with a locked loop circuit loop filter capacitor helps control a leakage current of the locked loop circuit loop filter capacitor, the chip area consumed by the locked loop circuit loop filter capacitor may be reduced because the locked loop circuit loop filter capacitor does not have to be as large to maintain the voltage potential on a control voltage signal.

While the invention has been described with respect to a limited number of embodiments, those skilled in the art, having benefit of this disclosure, will appreciate that other embodime nts can be devised which do not depart from the scope of the invention as disclosed herein. Accordingly, the scope of the invention should be limited only by the attached claims.

## Claims

1. An integrated circuit, comprising:
a detector arranged to detect a phase difference between a first clock signal and a second clock signal;
a charge pump arranged to output a control voltage signal dependent on the phase difference;
an on-chip capacitor operatively connected to the control voltage signal;
a diode operatively connected in series with the capacitor; and
a voltage-controlled device arranged to output the second clock signal dependent on the control voltage signal.

2. The integrated circuit of claim 1, wherein the diode is operatively connected to a voltage potential.

3. The integrated circuit of claim 2, wherein the voltage potential is ground.

4. The integrated circuit of claim 1, wherein the capacitor is a loop filter capacitor.

5. The integrated circuit of claim 1, wherein the capacitor is implemented with a transistor.

6. The integrated circuit of claim 1, wherein the diode is implemented with any one of a transistor and a p-n junction device.

7. The integrated circuit of claim 1, further comprising:
a bias generator arranged to output at least one bias signal dependent on th e control voltage signal.

8. An integrated circuit, comprising:
means for detecting a phase difference between a first clock signal and a second clock signal;
means for generating a signal dependent on the phase difference;
means for storing charge on -chip to maintain a voltage potential on the signal;
a diode positioned in series with the means for storing and arranged to control a leakage current of the means for storing charge; and
means for generating the second clock signal dependent on the signal.

9. The integrated circuit of claim 8, wherein the diode is operatively connected to one selected from the group consisting of a power supply and ground.

10. The integrated circuit of claim 8, wherein the diode is implemented with any one of a transistor and a p-n junction device.

11. A method for performing a locked loop circuit operation, comprising:
comparing a phase difference between a first clock signal and a second clock signal;
generating a control voltage signal dependent on the comparing;
storing charge dependent on the control voltage signal using an on -chip capacitor;
controlling a leakage current of the capacitor with a diode positioned in series with the capacitor; and
generating the second clock signal dependent on the control voltage signal.

12. The method of claim 11, wherein the diode and the capacitor are positioned between a voltage potential and the control voltage signal.

13. The method of claim 11, wherein the capacitor is a loop filter capacitor.

14. The method of claim 11, wherein the capacitor is implemented wit h a transistor.

15. The method of claim 11, wherein the diode is implemented with any one of a transistor and a p-n junction device.
